# EUROPEAN PATENT APPLICATION

(11) **EP 2 157 840 A1**
(43) Date of publication of application: **24.02.2010**
(21) Application number: 08765579.1
(22) Date of filing: 13.06.2008
(51) Int. Cl.: H05K 3/20, B44C 1/165

(54) **TRANSFER FILM FOR BURNING**

(30) Priority: 13.06.2007 JP 2007156490
(71) Applicant: Toppan TDK Label Co Ltd., Taito-ku Tokyo 110-0016 (JP); Nippon Sheet Glass Co., Ltd., Minato-ku Tokyo 108-6321 (JP)
(72) Inventor: IIKUMA, Akihiro, Tokyo 110-0016 (JP); SHINOZAKI, Hideaki, Tokyo 110-0016 (JP); KIKUCHI, Masahiro, Tokyo 110-0016 (JP); OTSUKA, Tatsuya, Tokyo 110-0016 (JP); KUBO, Taiichi, Tokyo 110-0016 (JP); ONO, Kazuhisa, Tokyo 108-6321 (JP)
(74) Representative: Müller-Boré & Partner Patentanwälte
(86) International application number: PCT/JP2008/060869
(87) International publication number: WO 2008/153137

(57) **Abstract**

A transfer film for firing which has a multilayer structure including a functional pattern and a pressure-sensitive adhesive layer. The multilayer structure is free from a shape failure of the functional pattern and a decrease in adhesive force of the adhesive layer, and has the excellent transferability to a substrate. The transfer film gives a fired functional pattern free from defects such as a shape or function failure. The transfer film for firing is one for use in forming a fired functional pattern by transferring a multilayer structure including a functional pattern to a surface of a substrate and firing it. The transfer film comprises a release film and a multilayer structure formed so as to be in contact with one of the surfaces of the release film. The multilayer structure includes a functional pattern and a contact layer which has been formed so as to be in direct contact with the surface of the functional pattern and is constituted of one layer or a larger number of layers. The functional pattern comprises inorganic particles and an organic substance removable by firing. The contact layer comprises an organic substance and a solvent both removable by firing. The organic substance contained in the functional pattern is incompatible with the solvent contained in the contact layer.

## Description

### TECHNICAL FIELD

The present invention relates to a transfer film for forming an electrically conductive pattern including a wiring circuit, electrodes, and the like or a decorative pattern, such as a pattern design, on a substrate of glass or the like, and particularly to a transfer film for firing that is suitable for a case where a functional pattern is transferred to the substrate, and thereafter is fired.

### BACKGROUND ART

Conventionally, the provision of functional patterns to substrates of glass, pottery, and the like has been performed in various fields. Examples of such provision include: formation of patterns, such as electric circuits, on substrates; decoration of potteries; formation of electrode patterns and ribs in plasma display panels; formation of antennas on glass plates mountable on vehicles, and the like.

As methods of forming such functional patterns, the photolithography / etching method, the screen printing method, the sputtering method and the like are widely adopted, for example. When a substrate has a smooth surface shape, the formation can be performed directly on the surface by adopting the above-described methods. However, when a substrate curves or is concavo-convex, none of the above methods can successfully be employed. For this reason, a transfer method has been examined in which a functional pattern is formed on a film in advance, and this functional pattern is transferred from the film to a substrate. With the transfer method, it is possible for the functional pattern to follow the contour of the substrate, irrespective of the dimensions and the shape of the substrate. Hence, the transfer method is excellent in patterning capability and productivity, and allows a functional pattern to be formed on any substrate at a low cost. For example, Patent Documents 1 to 5 describe such transfer films.

Patent Document 1 discloses a transfer paper for decorating potteries. In the transfer paper, plural colored layers and intermediate layers between the colored layers are sequentially formed by screen-printing on a base paper for printing, and a cover layer is provided at an uppermost part. Patent Document 3 discloses a transfer sheet for producing a plasma display panel. In the transfer sheet, a peelably provided transfer layer and a stress absorbing layer are provided on a base film, and the transfer layer contains inorganic components including glass frit and an organic component removable by firing. Here, the complex elastic modulus of the stress absorbing layer is smaller than the complex elastic modulus of the transfer layer. Patent Document 4 discloses an in-vehicle log-periodic dipole antenna in which a conductor pattern stacked on a transfer film is formed on a glass plate mountable on a vehicle by a transfer method. Patent Document 5 discloses a method for forming a pattern such as an electric circuit. This method includes forming a print pattern on a transfer film by using a glass paste, thermally transferring the print pattern onto a substrate, and firing the transferred print pattern. These are transfer films for firing with which functional patterns are formed by transfer to substrates followed by firing.
Patent Document 1: Japanese Patent Application Publication No. H05-139020
Patent Document 2: Japanese Patent Application Publication No. H11-135009
Patent Document 3: Japanese Patent Application Publication No. H11-260250
Patent Document 4: Japanese Patent Application Publication No. 2001-211020
Patent Document 5: Japanese Patent Application Publication No. 2000-151080

### DISCLOSURE OF THE INVENTION

### PROBLEMS TO BE SOLVED BY THE INVENTION

The laminate which is included in the transfer film for firing and which contains the functional pattern needs not only the functional pattern but also at least an adhesive layer to bond the functional pattern to the substrate. In addition, the laminate has a configuration in which some layers are stacked on one another, if necessary. The functional pattern at least contains an inorganic powder which is a functional material of one of various kinds that corresponds to the desired function of the functional pattern after firing; an inorganic powder which is thermally-fusible and which gives the mechanical strength after firing; and an organic material which keeps the shape before firing and which is removed by firing. The adhesive layer is made of an organic material that is removable by firing.

When fired at high temperatures, the organic materials are pyrolyzed at their respective temperatures specific to the organic materials, and removed as pyrolysis-gases. Meanwhile, the surfaces of particles of the inorganic powder in the functional pattern melt so that the particles of the inorganic powder fuse with one another, or with the substrate. In the transfer film for firing, the smaller amount of the organic material the functional pattern contains, the more excellent mechanical strength can be obtained after firing. Accordingly, the functional pattern can have the desired function. In addition, the smaller amount of the organic material is preferable from the viewpoint of the design of the functional pattern.

To fabricate the transfer film for firing, a peelable film, for example, is used as a supporting body, and layers including the functional pattern, the sticking layer, and the like are formed one upon another by a printing method or the like. While the layers are being formed, the organic material contained in the functional pattern and the solvent contained in the layer that is formed so as to be in direct contact with the functional pattern (hereinafter, referred to as a "contact layer") may form a combination that includes materials easily compatible with each other. In the case of such an easily-compatible combination, the material contained in the functional pattern and the material contained in the contact layer are sometimes mixed together. The mixing of the materials may cause the organic material contained in the functional pattern to be eluded out of the functional pattern, resulting in the shrinkage of the functional pattern. Alternatively, the mixing may cause the material contained in the contact layer to flow into the functional pattern, resulting in the swelling of the functional pattern. The shrinkage or the swelling may be a cause of such defects of the pattern shape as deformation and rupture. In addition, the flowing of the material from the functional pattern into the contact layer or the flowing of the material from the contact layer into the functional pattern sometimes prevents the contact layer from performing the function that the contact layer would otherwise perform. If the contact layer is a sticking layer, the flowing of the material sometimes results in a lower sticking performance of the sticking layer. The lower adhesive power sometimes results in a phenomenon that has an adverse effect on the firing of the functional pattern. If the functional pattern contains only a small amount of the organic material, the solvent contained in the layer formed so as to be in contact with the functional pattern is more likely to permeate the functional pattern. Accordingly, a smaller amount of the organic material contained the functional pattern is in particular likely to cause an adverse effect on the firing of the functional pattern.

Accordingly, an object of the invention is to provide a transfer film for firing with the following features. The transfer film for firing includes a laminate including a functional pattern that does not cause a defective shape of the functional pattern or a lower sticking performance of a sticking layer. The transfer film for firing has an excellent transferability to the substrate. The transfer film for firing does not allow a fired body of a functional pattern to be formed on a substrate, without such defects as defective shape and defective function.

### MEANS FOR SOLVING THE PROBLEMS

The present invention is a transfer film for firing used for forming a fired body of a functional pattern by transferring a laminate having the functional pattern to a surface of a substrate, followed by firing, the transfer film for firing **characterized in that** the transfer film for firing includes: a peelable film; and the laminate that is formed so as to be in contact with one of surfaces of the peelable film, the laminate further includes: a functional pattern; and a contact layer which is formed of a single or more layers, and which is formed so as to be in direct contact with one of surfaces of the functional pattern, the functional pattern contains: an inorganic powder; and an organic material that is removable by firing, the contact layer contains: an organic material that is removable by firing; and a solvent, and the organic material contained in the functional pattern is not compatible with the solvent contained in the contact layer.

According to one embodiment of the present invention, a solubility parameter (SPb) of the organic material contained in the functional pattern and a solubility parameter (SP) of the solvent contained in the contact layer satisfy a relation of 5 < |SP - SPb|.

According to another embodiment of the present invention, the contact layer is a sticking layer that is bonded to the surface of the substrate before the laminate is transferred to the substrate.

According to still another embodiment of the present invention, the laminate further includes a sticking layer that is bonded to the surface of the substrate when the laminate is transferred to the substrate, and the contact layer is an intermediate layer that is sandwiched between the functional pattern and the sticking layer.

According to yet another embodiment of the present invention, one layer in the contact layer is a protective layer provided to protect one of the surfaces of the functional pattern that is indirectly in contact with that the one surface of the peelable film.

### EFFECTS OF THE INVENTION

The transfer film for firing according to the present invention includes the peelable film and the laminate that is formed so as to be in contact with the one of the surfaces of the peelable film. The laminate includes the functional pattern containing the inorganic powder and the organic material that is removable by firing. The laminate also includes the contact layer which has either a single or more layers, and which is formed so as to be in direct contact with the one of the surfaces of the functional pattern. The contact layer contains the organic material that is removable by firing and the solvent. The transfer film for firing is **characterized in that** the organic material contained in the functional pattern is not compatible with the solvent contained in the contact layer. The solvent does not dissolve the organic material contained in the functional pattern, so that the material of the functional pattern and the material of the contact layer do not mix with each other. Accordingly, there can be obtained a transfer film for firing having no such defects of the functional pattern as deformation or rupture.

In addition, when another layer is additionally formed in the laminate including the functional pattern, the additionally-formed layer is formed with the contact layer being imposed between the laminate and the additionally-formed layer. Accordingly, the functional pattern is not in direct contact with the additionally-formed layer. Consequently, the solvent contained in the additionally-formed layer has no influence on the organic material contained in the functional pattern. For example, the additionally-formed layer may be an adhesive layer which has so excellent adhesiveness that the laminate including the functional pattern can be transferred to the substrate. Accordingly, there can be obtained a transfer film for firing having no such defects of the functional pattern as deformation or rupture and having an excellent transferability to the substrate.

### BEST MODES FOR CARRYING OUT THE INVENTION

What follows is a detailed description of the present invention.

### (EMBODIMENT 1)

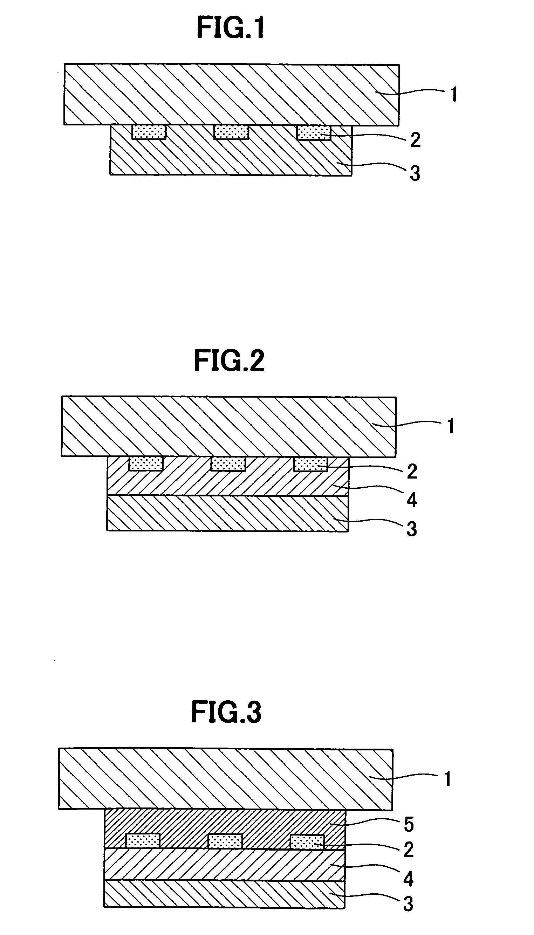

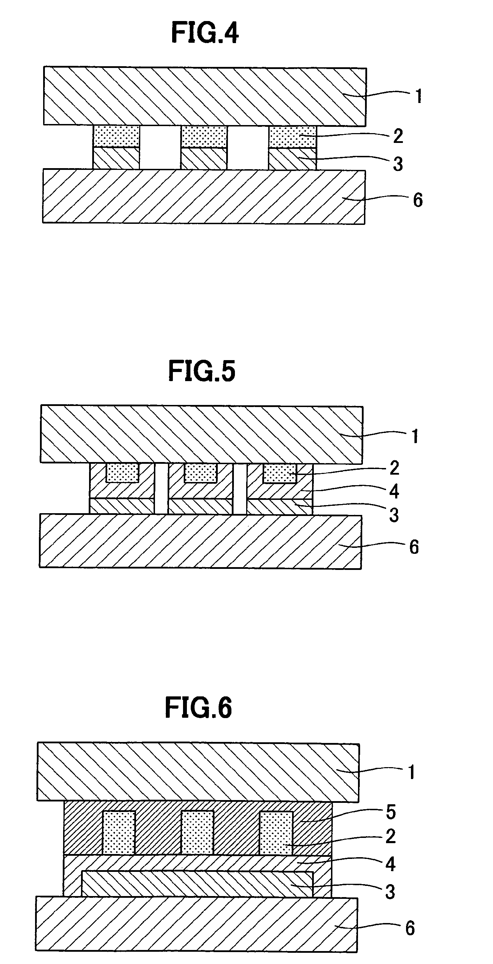

Fig. 1 and Fig. 4 are enlarged schematic sectional diagrams each of which illustrates an exemplar configuration of a transfer film for firing according to Embodiment 1 of the present invention. The transfer film for firing of the example shown in Fig. 1 includes a peelable film 1 and a laminate that includes a functional pattern formed so as to be in contact with one of the surfaces of the peelable film. The transfer film for firing of the example shown in Fig. 4 includes a first peelable film 1, a second peelable film 6, and a laminate that includes a functional pattern formed between the first peelable film 1 and the second peelable film 6.

The laminate includes a functional pattern 2 containing both an inorganic powder and an organic material removable by firing. The laminate also includes a sticking layer 3 containing an organic material removable by firing and a solvent.

In each of these examples, the functional pattern is expressed as a collection of plural lines that are arranged in a substantially equidistant manner. In the example shown in Fig. 4, the sticking layer 3 is formed as substantially the same pattern as the functional patter, but each of the sticking layer 3 and the functional pattern is not formed continuously. Nevertheless, in the present invention, each of the patterns like these is considered as a single layer.

In the configuration of this laminate, the sticking layer 3 is in direct contact with the functional pattern 2, so that the sticking layer 3 serves as a contact layer. In the example shown in Fig. 1, the contact layer 3 is formed so as to cover all the lines of the functional pattern 2 whereas, in the example shown in Fig. 4, the contact layer 3 is formed so as to have the same pattern as the functional pattern 2. In the example shown in Fig. 4, the second peelable film 6 is additionally formed so as to be in contact with the adhesive layer 3.

If the laminate is formed with the (first) peelable film 1 being used as a supporting body, the second peelable film 6 is not an essential component. The second peelable film 6, however, serves as a protector for the laminate while the transfer film for firing is stored or until the laminate is transferred to a substrate. If the laminate is formed with the second peelable film 6 being used as a supporting body, the second peelable film 6 may be removed after forming the laminate, or may remain without being removed even after the formation.

### (EMBODIMENT 2)

Fig. 2 and Fig. 5 are enlarged schematic sectional diagrams each of which illustrates an exemplar configuration of a transfer film for firing according to Embodiment 2 of the present invention. A laminate including a functional pattern of this configuration includes an intermediate layer 4 formed between the functional pattern 2 and the sticking layer 3 of the laminate shown in Embodiment 1. The intermediate layer 4 contains an organic material removable by firing and a solvent. In the configuration of this laminate, the intermediate layer 4 is in direct contact with the functional pattern 2, so that the intermediate layer 4 serves as a contact layer.

### (EMBODIMENT 3)

Fig. 3 and Fig. 6 are enlarged schematic sectional diagrams each of which illustrates an exemplar configuration of a transfer film for firing according to Embodiment 3 of the present invention. A laminate including a functional pattern of this configuration further includes a protective layer 5 formed on the opposite side of the functional pattern 2 from the sticking layer 3, that is, formed directly on a surface of the (first) peelable film 1, which are shown in Embodiment 2. The protective layer 5 contains an organic material removable by firing and a solvent. In the configuration of this laminate, the intermediate layer 4 and the protective layer 5 are in direct contact with the functional pattern 2, so that both the intermediate layer 4 and the protective layers 5 serve as contact layers. Note that the intermediate layer 4 is not an essential component of Embodiment 3. With the configuration of the laminate without the intermediate layer 4, the sticking layer 3 and the protective layer 5 are in direct contact with the functional pattern 2, so that both the sticking layer 3 and the protective layer 5 serve as contact layers.

If the transfer film for firing shown in any of Embodiment 1 to Embodiment 3 includes the second peelable film 6, the second peelable film 6 is peeled off, and then the sticking layer 3 is pasted to a surface of the substrate (unillustrated). After that, by peeling off the (first) peelable film 1, the laminate including the functional pattern is transferred to the surface of the substrate. The substrate with the laminate transferred thereon is then subjected to a firing process. Thereby, the fired body of the functional pattern is given to the surface of substrate.

What follows is a description of the components of the transfer film for firing.

Each peelable film serves as a supporting body when the functional pattern, the sticking layer, the intermediate layer, and the protective layer all of which are included in the laminate including the functional pattern are formed by a printing method or the like.

Each peelable film has only to be peelable from the laminate including the functional pattern. A film base material may be used as the peelable film without any additional component. When necessary, the peelable film may have a configuration in which a peelable layer made of, for example, a silicone-based or alkyd resin-based material is formed on the film base material. Alternatively, when necessary, the peelable film may have a configuration including a weakly sticking layer for peeling a second time. If the second peelable film is formed on the surface of sticking-layer side of the laminate including the functional pattern, the load for peeling the second peelable film must be lighter than the load for peeling the first peelable film. The bonding strength at the peeling interface can be adjusted by the kind of film base material or of the peelable layer, the film thicknesses, or the like.

The base material for the peelable film is preferably a flexible material in consideration of workability in transferring the laminate. Some examples of such usable flexible materials are: plastics such as polyethylene, polyimide, polyethylene terephthalate, acryl; and paper. The thickness of the base material is not limited to a certain range, and an optimal thickness may be selected by taking account of the balance among the pressure at the time of the transferring operation, the heat transferability and the flexibility of the film. In view of the convenience in the fabrication of the peelable film and in the transferring of the laminate, a preferable thickness ranges from 25 µm to 250 µm, a preferable thickness ranges from 35 µm to 125 µm, and a more preferable thickness ranges from 50 µm to 75 µm.

Some of the possible methods employable to form the functional pattern and the layers on top of or above the peelable film are: various printing methods, such as the screen printing and the offset printing; and various coating methods, such as the gravure coating and the Meyer bar coating. To form the pattern, the printing methods are preferably employed. Not only the printing methods but also the coating methods are preferably employed to form a uniform layer of a broad area.

To form the functional pattern or each of the layers by the printing methods or the coating methods, a coating liquid (paste) to be used for this purpose is prepared by either dispersing or dissolving, into the solvent, the inorganic powder or the organic material to be contained in the functional pattern or the layer. The solvent is selected by taking account of the solubility or the dispersibility of the organic material and the boiling point that is appropriate for the printing process. Some examples of such possible solvents are: water-based solvents; alcohol-based solvents; ketone-based solvents; ester-based solvents; ether-based solvents and hydrocarbon-based solvents. Each of these solvents may be used either by itself or in combination with others. Before use, the viscosity, the thixotropy, and the other properties of the solvent should be adjusted appropriately for the printing process. The solid content of the solvent is also be adjusted. Most of each of the solvents vaporizes after the printing or the coating of the functional pattern. The remaining part of the solvent is made to vaporize by firing, or is decomposed and removed by firing.

Various types of additives may be used when necessary. Some examples of the additives are: a defoaming agent to reduce the bubbles that are formed at the time of printing; and a thickening agent to adjust the viscosity. The additives that are decomposable and removable by firing must be used.

The functional pattern contains an inorganic powder which mainly functions to exhibit the mechanical strength after firing and which is thermally fusible to the substrate, another inorganic powder which is a functional material of various kinds corresponding to the desired functions to be obtained after firing, and an organic material which maintains the shape before firing, and which is removed by firing.

Either a single functional pattern or plural functional patterns may be included in a single transfer film for firing. For example, plural antenna patterns may be formed in a single transfer film for firing. In addition, plural functional patterns may be formed respectively in plural layers formed on upon another. For example, a conducive functional pattern may be formed so as to be covered by another functional pattern of insulation. The film thickness of each functional pattern is determined appropriately for the function.

The thermally-fusable inorganic powder contained in the functional pattern is provided for the purposes of, for example, making the substrate carry the functional materials of various kinds after firing and improving the durability. An example of the possible materials to be used for this purpose is glass frit. A glass frit of an appropriate composition may be selected by taking account of the balance among such factors as the firing temperature and the thermal shrinkage ratio.

The functional materials contained in the functional pattern should be selected, as appropriate, for use, so as to correspond to the desired functions to be obtained after firing. For example, for wiring, electrodes, or the like, powders of Au, Ag, Cu, Ni, Co, Sn, Pb, Zn, Bi, and In can be used. Powders of alloys containing above-mentioned metals may also be used for the same purposes. Some examples of the materials used as dielectrics such as capacitor parts or as highly-resistive parts are powders of BaTiO, SiC, TiO₂, SiI₂, and RuO.

The organic material contained in the functional pattern is not limited to a certain material as long as the material is removable by firing. Some examples of the organic material are such resins as acryl, methylcellulose, nitrocellulose, ethylcellulose, vinyl acetate, polyvinyl butyral, polyvinyl acetal, polyvinyl alcohol, polyethylene oxide, and polyester. Each of these resins may be used by itself, or a mixture of these resins may be used as the main component of the organic material. In addition, as a supplementary organic component, a plasticizer may be added for the purpose of giving flexibility to the coating film before firing. Some examples of the plasticizer to be used for this purpose are fatty-acid ester based plasticizers, phosphate ester based plasticizer, and the like.

It is important, however, for the organic material contained in the functional pattern to be incompatible with the solvent contained in the coating liquid used to form the contact layer (hereafter the coating liquid will be referred to as the "contact-layer paste"). This is important especially when the contact-layer paste is coated on the functional pattern that has been formed beforehand. Conversely, when the functional pattern is formed on the contact layer that has been formed beforehand, it is possible to reduce the influence of the compatibility by making most of the solvent vaporize and be removed from the contact layer. Also in this case, however, it is important for the organic material contained in the functional pattern to be incompatible with the solvent contained in the contact layer.

In general, two substances having a larger difference between their respective solubility parameters are less likely to be compatible with each other while two substances having a smaller solubility-parameter difference is more likely to be compatible. It is preferable that the solubility parameter (SP) of the solvent contained in the contact layer and the solubility parameter (SPb) of the organic material contained in the functional pattern should satisfy 5 < |SP - SPb|. Note that, if a supplementary organic component is added, the solubility parameter of the supplementary organic component has to be taken account of as well. Nevertheless, if the amount of the added supplementary organic component is small, the influence of the supplementary organic component is ignorable. In addition, even when the functional pattern is formed on the contact layer that has been formed beforehand, it is preferable that the relation 5 < |SP - SPb| should be satisfied. In this case, the difference between the solubility parameter of the organic material contained in the contact layer and the solubility parameter of the solvent contained in the functional pattern is considered as the difference between the solubility parameter (SP) of the solvent contained in the contact layer and the solubility parameter (SPb) of the organic material contained in the functional pattern.

For example, suppose a case where an ethylcellulose resin is used as the organic material contained in the functional pattern. The solubility parameter (SPb) of the ethylcellulose resin ranges from 10 to 12. If water (solubility parameter (SP) = 23.4) is used as the solvent contained in the contact layer formed on the functional pattern, the absolute value of the difference between these solubility parameters (hereafter, simply referred to as the "solubility-parameter difference") |SP - SPb| falls within a range from 11.4 to 13.4. The value of this solubility-parameter difference means that the ethylcellulose resin and water are less likely to be compatible with each other. In contrast, if toluene (solubility parameter (SP) = 8.9) is used as the solvent contained in the contact layer, the solubility-parameter difference falls within a range from 1.1 to 3.1. The value of this solubility-parameter difference means that the ethylcellulose resin and toluene are more likely to be compatible with each other.

The solubility parameter of a compound material can be obtained as the sum of the products each of which is obtained by multiplying the weight ratio of the component material by the solubility parameter thereof. For example, the solvent is a mixture solvent containing 50 parts of water (solubility parameter = 23.4) and 50 parts of isopropyl alcohol (solubility parameter = 11.4), the solubility parameter of the mixture solvent is 17.4 (= 23.4 × 0.5 + 11.4 × 0.5).

The organic material of the sticking layer is not limited to specific ones as long as the organic material is removable by firing. Any sticking agent that is sticky at normal temperature, such as an acryl-based sticking agent or a rubber-based sticking agent, can be used for the sticking layer.

The sticking layer may be formed in a similar pattern to the functional pattern so as to be laid over the functional pattern (see Fig. 4). Alternatively, the sticking layer may be formed so as to cover the functional pattern to the extent that the functional pattern is not exposed (see Fig. 5). These ways of forming the sticking layer can save the material for the sticking layer if the constituent parts of the functional pattern are formed away from one another over a broad area. However, when the sticking layer is formed in the similar pattern to the functional pattern or so as to just cover the functional pattern, it is sometimes difficult to secure sufficient sticking performance of the sticking layer. It is especially difficult if the functional pattern is formed, for example, with fine lines and/or small dots. So, in these cases, the sticking layer may be formed broadly enough to secure the necessary sticking performance, or may be formed so as to cover entirely the supporting body being the peelable film (see Fig. 1).

As shown in Embodiment 1, if the sticking layer serves as the contact layer and is in direct contact with the functional pattern, it is important for the solvent used for forming the contact layer to be incompatible with the organic material contained in the functional pattern, as described above.

The film thickness of the sticking layer is within a range from 1 µm to 20 µm, and is preferably within a range from 2 µm to 10 µm. A film thickness that is smaller than 1 µm makes the sticking performance so insufficient that transferability becomes poor. A film thickness that is larger than 20 µm results in so large a pyrolysis-gas generation amount that the functional pattern is more likely to have some defects and to result in problems in the firing process. For these reasons, the film thickness of the sticking layer is preferably as thin as possible unless the necessary sticking performance is impaired. If the sticking layer serves as the contact layer, the sticking layer preferably has a film thickness within the above-mentioned range at least in the portions where the functional pattern is formed.

As shown in Embodiment 2 of the present invention, an intermediate layer may be provided between the functional pattern and the sticking layer. The material for the functional pattern and the material for the sticking layer are selected independently of each other in accordance with their respective functions, so that there may be a case where the organic material contained in functional pattern and the solvent contained in the sticking layer may form a combination of materials that are likely to be compatible with each other. In this case, the intermediate layer serves as a barrier between the functional pattern and the sticking layer. The organic material for the intermediate layer is not limited to a certain material as long as the organic material is removable by firing. The organic material for the intermediate layer may be selected from a group of organic materials that are used for the functional pattern. Nevertheless, the organic material for the intermediate layer is preferably selected so that the combination of the selected organic material and the organic material contained in the functional pattern can be incompatible with each other. In addition, an especially preferable organic material for the intermediate layer is a polymer resin that has a glass-transition temperature of 50°C or higher.

The intermediate layer has to be formed so as to prevent the functional pattern and the sticking layer from being in direct contact with each other. The intermediate layer does not have to be formed in the portions where no functional pattern exists (see Fig. 5). If the intermediate layer has such dimensions that make the intermediate layer be laid over the sticking layer, foreign objects are prevented from adhering to the sticking layer having a strong sticking performance, which would otherwise occur after the laminate including the functional pattern is transferred to the substrate.

As described above, if the intermediate layer serves as the contact layer and is in direct contact with the functional pattern, it is important that the solvent used for forming the contact layer should be incompatible with the organic material contained in the functional pattern.

If the intermediate layer has a film thickness of 0.5 µm or larger in the portions where the functional pattern is formed, the intermediate layer has sufficient barrier effects. It is, however, preferable for the portions of the intermediate layer to have a film thickness of 1 µm or larger. The intermediate layer having a larger film thickness results in so large a pyrolysis-gas generation amount that the functional pattern is more likely to have some defects and to result in problems in the firing process. For these reasons, the film thickness of the intermediate layer is 10 µm or smaller, and is preferably 5 µm or smaller. To put it differently, it is preferable that the film thickness should be as thin as possible.

As shown in Embodiment 3 of the present invention, a protective layer may be formed between the peelable film and the functional pattern. The protective layer has a role of protecting the functional pattern which has been transferred to and formed on the substrate until the substrate with the functional pattern is fired. The protective layer protects the functional pattern against the attaching of foreign objects and against impacts that would otherwise leave scars. The functional pattern has only a small proportion of the organic-material content, and thus tends to have a hard and fragile film property before firing. For this reason, if the transfer film is bent, cracks are likely to be formed in the functional pattern. Cracks can be prevented by sandwiching the hard and fragile layer by two softer and more flexible layers. Accordingly, the protective layer, together with the sticking layer and the intermediate layer, has a role of preventing cracks and the like from being formed when the film is bent. The organic material for the protective layer is not limited to a certain material as long as the organic material is removable by firing. The organic material for the protective layer may be selected from a group of organic materials that are used for the functional pattern. Nevertheless, the organic material for the protective layer is preferably selected so that the combination of the selected organic material and the organic material contained in the functional pattern can be incompatible with each other.

As described above, if the protective layer serves as the contact layer and is in direct contact with the functional pattern, it is important that the solvent used for forming the contact layer should be incompatible with the organic material contained in the functional pattern.

The protective layer has only to be formed so as to cover the functional pattern. The protective layer may be formed in a similar pattern shape to the functional pattern. If there is a portion where no intermediate layer is formed between the sticking layer and the protective layer, it is preferable that the protective layer should be formed so as to be laid over the sticking layer. These ways of forming the protective layer can prevent foreign objects from adhering to the sticking layer having strong sticking performance, which would otherwise occur after the laminate including the functional pattern is transferred to the substrate.

The film thickness of the protective layer is preferably within a range from 0.1 µm to 2 µm in the portions where the functional pattern is formed.

### EXAMPLES

What follows is a description of some specific examples of the present invention. These examples, however, do not limit the invention by any means.

### (Example 1)

### (Fabrication of Transfer Film for Firing)

A transfer film for firing described in Embodiment 1 was fabricated by the following procedure.

As the peelable film, a PET film including a silicone-based mold-release layer and known as "A70" (manufactured by Teijin DuPont Films Japan Limited, film size: 20 cm × 30 cm, thickness: 50 µm) was prepared.

As the coating liquid for the functional pattern, a color paste containing a black pigment and a glass frit was prepared in accordance with the composition shown in Table 1. A three-roll mixer was used for the preparation. The organic material which is contained in the color paste and which is removable by firing had a solubility parameter (SPb) of 11.

As the coating liquid for the sticking layer, a sticking-layer paste was prepared by diluting an acryl-based sticking agent "RIKABOND® S200" (manufactured by Chuo Rika Kogyo Co., Ltd.) with water (solubility parameter (SP) = 23.4) as the solvent.

On the mold-release layer of the peelable film, the color paste was printed using a screen-printing machine so as to give a size of 2 cm × 5 cm and a film thickness of 15 µm. Thus, the functional pattern was formed.

The sticking-layer paste was coated using a Meyer bar coating machine so as to be laid over the functional pattern and to give a size of 2 cm × 5 cm and a film thickness of 3 µm. Thus, the sticking layer was formed.

The resultant substrate was then dried at 120°C for 10 minutes.

### (Fabrication of Substrate with Functional Pattern)

A substrate with a functional pattern was fabricated by the following procedure.

As the substrate, a glass plate (size: 30 cm × 30 cm) manufactured by the float process was prepared.

The sticking layer of the transfer film for firing was faced to a surface of the glass plate, and the transfer film for firing was pasted thereto with a pressure of 0.5 kg/cm applied, using a rubber roller, onto the first peelable film. Then, the peelable film was peeled off. Thus fabricated was a glass plate to which a laminate including a functional pattern had been transferred.

Then, the glass plate thus fabricated was fired in a firing furnace. The firing conditions were: the temperature was raised from room temperature up to 650°C at a rate of temperature increase of 500°C/min; this temperature was kept for 30 minutes; then the glass plate was radiatively cooled in the furnace down to 100 °C or even lower.

After that, the cooled glass plate with a functional pattern was taken out of the firing furnace.

**[Table 1]**

| Composition | Part by weight |
|---|---|
| Black pigment of CrCu oxide | 15 |
| Borosilicate glass frit | 65 |
| Ethylcellulose | 5 |
| Pine oil | 15 |

### (Comparative Example 1)

As the coating liquid for the sticking layer, a sticking-layer paste was prepared by diluting an acryl-based sticking agent "SK1309" (manufactured by Soken Chemical & Engineering Co., Ltd.) with a mixture solvent of 50-part toluene and 50-part ethyl acetate. The mixture solvent had a solubility parameter (SP) of 9.

A transfer film for firing was fabricated following the rest of the procedure that was similar to the corresponding part of the procedure employed in Example 1.

Fabrication of a glass plate to which the laminate including a functional pattern had been transferred was tried by a similar method to the one employed in Example 1, but the transferring of the laminate failed.

### (Assessment)

Table 2 shows: the solubility parameter of the organic material contained in the functional pattern; the solubility parameter of the solvent contained in the adhesive layer; the difference between these solubility parameters; the assessment of the transferability; and the assessment of the firing ability. Table 2 shows these data both for Example 1 and for Comparative Example 1. The assessment of the transferability is shown by the following symbols: "○" meaning that the transfer was favorably done with no such defects as distortion and floating observed in the laminate including a functional pattern; and "×" meaning that the transfer failed and was thus defective. The assessment of the firing ability is shown by the following symbols: "○" meaning that the firing was favorably done with no such defects as distortion, cracks, and flaking observed in the fired body of the functional pattern; and "-" meaning that the firing failed.

Example 1 had favorable assessment results of both the transferability and the firing ability. In the case of Comparative Example 1, on the other hand, the transferring of the laminate including a functional pattern failed, so that no firing was performed.

**[Table 2]**

| | Solubility parameter | | Solubility parameter difference \|SP - SPb\| | Assessment | |
|---|---|---|---|---|---|
| | Functional pattern SPb | Adhesive layer SP | | Transferability | Firing ability |
| Example 1 | 11 | 23.4 | 12.4 | ○ | ○ |
| Comparative Example 1 | 11 | 9 | 2 | × | - |

### (Comparison)

Example 1 and Comparative Example 1 is compared with each other.

In Example 1, the solubility-parameter difference between the organic material contained in the functional pattern and the solvent contained in the sticking-layer paste was 12.4 as shown in Table 2. This value means that the organic material and the solvent were hardly compatible with each other. In contrast, Comparative Example 1 had the corresponding solubility-parameter difference of 2 as shown in Table 2. This value means that the organic material and the solvent were likely to be compatible with each other. It can be considered as follows. In Example 1, the organic material contained in the functional pattern was not dissolved in the solvent which was contained in sticking-layer paste and which remained in the sticking layer even after the formation of the sticking layer. Consequently, a favorable functional pattern was obtained, and the sticking layer did not lose its stickiness. In contrast, in Comparative Example 1, the organic material contained in the functional pattern was dissolved in the mixture solvent which was contained in the sticking-layer paste and which remained in the sticking layer even after the formation of sticking layer. Consequently, no favorable functional pattern was obtained. In addition, the dissolved organic material was mixed into the sticking layer, so that the sticking layer lost its stickiness.

### Example 2

### (Fabrication of Transfer Film for Firing)

A transfer film for firing described in Embodiment 2 was fabricated by the following procedure.

As the first peelable film, a PET film similar to the one used in Example 1 was prepared.

As the second peelable film, a PET film including a silicone-based mold-release layer and known as "A31" (manufactured by Teijin DuPont Films Japan Limited, film size: 20 cm × 30 cm, thickness: 25 µm) was prepared.

As the coating liquid for the functional pattern, a color paste similar to the one used in Example 1 was fabricated.

As the coating liquid for the intermediate layer, an intermediate-layer paste was prepared by diluting a polyvinyl-acetal-based resin known as "KW3" (manufactured by Sekisui Chemical Co., Ltd.) with a mixture solvent of 50-part water and 50-part isopropyl alcohol. This mixture solvent had a solubility parameter (SP) of 18.

As the coating liquid for the sticking layer, a sticking-layer paste similar to the one used in Comparative Example 2 was prepared.

On the mold-release layer of the first peelable film, the conductive paste was printed using a screen-printing machine so as to give a size of 2 cm × 5 cm and a film thickness of 15 µm. Thus, the functional pattern was formed.

The intermediate-layer paste was coated using a Meyer bar coating machine so as to cover the functional pattern and to give a size of 5 cm × 10 cm and a film thickness of 2 µm on the functional pattern. Thus, the intermediate layer was formed.

The sticking-layer paste was coated using a Meyer bar coating machine so as to be laid over the intermediate pattern and to give a size of 5 cm × 10 cm and a film thickness of 3 µm on the intermediate layer. Thus, the sticking layer was formed.

The second peelable film was bonded from the mold-release-layer side so as to cover the sticking layer.

### (Fabrication of Substrate with Functional Pattern)

A substrate with a functional pattern was fabricated by the following procedure.

As the substrate, a glass plate (size: 30 cm × 30 cm) manufactured by the float process was prepared.

The second peelable film was peeled off from the transfer film for firing. The sticking layer of the transfer film for firing was faced to a surface of the glass plate, and the transfer film for firing was pasted thereto with a pressure of 0.5 kg/cm applied, using a rubber roller, onto the first peelable film. Then, the first peelable film was peeled off. Thus fabricated was a glass plate to which a laminate including a functional pattern had been transferred.

Then, the glass plate thus fabricated was fired in a firing furnace, so that a glass plate with a functional pattern was fabricated. The firing conditions were: the temperature was raised from room temperature up to 650 °C at a rate of temperature increase of 500°C/min; this temperature was kept for 10 minutes; then the glass plate was radiatively cooled in the furnace down to 100°C or even lower.

After that, the cooled glass plate with a functional pattern was taken out of the firing furnace.

### (Comparative Example 2)

As the coating liquid for the intermediate layer, an intermediate-layer paste was prepared by diluting a butyral-based resin known as "BM-1" (manufactured by Sekisui Chemical Co. , Ltd.) with a solvent of toluene (solubility parameter (SP) = 8.9).

A transfer film for firing was fabricated by a similar method to the one employed in Example 2 except the above-described preparation of the coating liquid for the intermediate layer. In the case of Comparative Example 2, however, no uniform intermediate layer was formed in the portion where the functional pattern and the intermediate layer were in contact with each other. Likewise no uniform adhesive layer was formed on the intermediate film of this portion.

The transferring of the laminate including a functional pattern onto a surface of a glass plate was tried by a similar method used in Example 2, but there was a portion where no laminate was transferred. Accordingly, no firing was performed.

### (Comparative Example 3)

As the coating liquid for the intermediate layer, the same intermediate-layer paste as the one used in Comparative Example 2 was used.

The film thickness of the intermediate layer was 5 µm, and the film thickness of the sticking layer was 10 µm. A transfer film for firing was fabricated by a similar method to the one employed in Comparative Example 2 except the film thicknesses.

Then, a glass plate with a functional pattern was fabricated by a similar method to the one used in Example 2.

### (Assessment)

Table 3 shows: the solubility parameter of the organic material contained in the functional pattern; the solubility parameter of the solvent contained in the adhesive layer; the difference between these solubility parameters; the assessment of the transferability; and the assessment of the firing ability. Table 3 shows these data for Example 2 and for Comparative Examples 3 and 4. The assessment of the transferability is shown by the following symbols: "○" meaning that the transfer was favorably done with no such defects as distortion and floating observed in the laminate including a functional pattern; and "×" meaning that the transfer failed and was thus defective. The assessment of the firing ability is shown by the following symbols: "○" meaning that the firing was favorably done with no such defects as distortion, cracks, and flaking observed in the fired body of the functional pattern; "×" meaning that there was a defect, and "-" meaning that the firing failed.

**[Table 3]**

| | Solubility parameter | | Solubility parameter difference \|SP - SPb\| | Assessment | |
|---|---|---|---|---|---|
| | Functional pattern SPb | Intermediate layer SP | | Transferability | Firing ability |
| Example 2 | 11 | 18 | 7 | ○ | ○ |
| Comparative Example 2 | 11 | 8.9 | 2.1 | × | - |
| Comparative Example 3 | 11 | 8.9 | 2.1 | ○ | × |

Example 2 had favorable assessment results of both the transferability and the firing ability. In the case of Comparative Example 2, on the other hand, there was a portion where the transferring of the laminate including a functional pattern failed, so that the assessment result of the transferability was unfavorable. Accordingly, it was evident that, even if the glass plate had been fired, the assessment result of the firing ability would have been unfavorable as well. For this reason no firing was performed. In the case of Comparative Example 3, the assessment result of the transferability was favorable, but the assessment result of the firing ability was unfavorable. This is because there occurred color fading, cracks, and unsatisfactory adhesion in some parts of the fired body of the functional pattern after firing.

### (Comparison)

Firstly, Comparative Example 2 is compared with Comparative Example 3.

The intermediate layer and the sticking layer of the laminate including the functional pattern in Comparative Example 2 were made of the same materials as those used in Comparative Example 3. The differences between Comparative Examples 2 and 3 are the film thicknesses of the layers. The film thicknesses of the layers in Comparative Example 3 were formed to be larger than the film thicknesses of the corresponding layers in Comparative Example 2.

The combination of the organic material contained in the functional pattern and the solvent contained in the intermediate layer had a solubility-parameter difference of 2.1, which means that the combination was likely to be compatible. In addition, the combination of the organic material contained in the functional pattern and the solvent contained in the sticking layer had a solubility-parameter difference of 2, which means that the combination was also likely to be compatible. In addition, the solvent contained in the intermediate layer had a solubility parameter of 8.9, and the solvent contained in the sticking layer had a solubility parameter of 9, which was substantially the same as the solubility parameter of 8.9 for the solvent contained in the intermediate layer. Accordingly, it is found that these two layers were likely to be mixed together. Consequently, it is found that the organic material contained in the functional pattern was likely to be mixed with each of the solvents or the organic materials contained in the intermediate layer and in the sticking layer.

In the case of Comparative Example 2, the film thicknesses of the intermediate layer and the sticking film were thin, so that the above-mentioned mixing occurred to a greater extent. The mixing of such a greater extent was the possible reason for the weaker sticking performance of the sticking layer. In contrast, in the case of Comparative Example 3, the film thicknesses of the intermediate layer and the sticking layer were thick, so that the extent of the mixing may have been not so great as to weaken the sticking performance of the sticking layer. Nevertheless, the organic material contained in the functional pattern was partially dissolved and mixed with the solvents and the organic materials of the intermediate layer and/or the sticking layer. The defects occurred in the fired body of the functional pattern may have been caused by such mixing.

The comparison of Comparative Example 2 and Comparative Example 3 leads to the following observation. Even if the organic material contained in the functional pattern and the solvent contained in the sticking layer has a small solubility-parameter difference and the combination is the one that is likely to be compatible, favorable transferability can still be obtained by forming the intermediate layer and/or the sticking layer so as to have larger film thicknesses. It is not possible, however, to obtain a fired body of a favorable functional pattern by increasing the film thicknesses.

Subsequently, Example 2 is compared with Comparative Example 2.

The laminate including the functional pattern in Example 2 and the corresponding laminate in Comparative Example 2 differ from each other only in the materials in their respective intermediate films. In the case of Example 2, the organic material contained in the functional pattern and the solvent contained in the intermediate layer had a solubility-parameter difference of 7, so that the organic material and the solvent formed a combination that was not likely to be compatible. It can be considered as follows. Even though the film thicknesses of the intermediate film and of the sticking film in Example 2 were the same as the corresponding film thicknesses of the intermediate film and the sticking film in Comparative Example 2, favorable results were obtained both for the transferability and the firing ability.

The comparison of Example 2 and Comparative Example 2 leads to the following observation. Even if the combination of the organic material contained in the functional pattern and the solvent contained in the sticking layer is likely to be compatible, the transferability and the firing ability can be improved by forming an intermediate layer between the functional pattern and the sticking layer. To this end, the intermediate layer must contain a solvent that is unlikely to be compatible with the organic material contained in the functional pattern. This means that, by providing an intermediate layer that serves as a barrier, the material of the sticking layer can be determined only on the basis of the function of the sticking layer. To put it differently, the material of the sticking layer can be determined independently of whether the material is more or less likely to be compatible with the organic material contained in the functional pattern. Accordingly, the viscosity of the coaling liquid can, for example, be adjusted more freely using the solvent for the purpose of adjusting the stickiness or adjusting the film thickness, or the like.

Subsequently Example 2 is compared with Comparative Example 3.

The total film thickness of the intermediate layer and the sticking layer was 5 µm in Example 2 whereas the corresponding total film thickness in Comparative Example 3 was 15 µm. Accordingly, it is found that the amount of the pyrolysis gas generated from the organic materials contained in the intermediate layer and the sticking layer in Comparative Example 3 was more than the corresponding amount of the pyrolysis gas in Example 2. The relatively large amount of the pyrolysis gas in Comparative Example 3 may have given a relatively large pressure to the ununiformly-formed functional pattern. Such a large pressure was a possible cause for the defects that occurred in the functional pattern. This leads to the following observation. By forming an intermediate layer serving as a barrier between the functional pattern and the sticking layer, even a relatively small total film thickness of the intermediate layer and the sticking layer does not impair the stickiness of the sticking layer. In addition, the forming of the intermediate layer can reduce the influence on the functional pattern by the pyrolysis gas generated from the organic material contained in the intermediate layer and the sticking layer.

The comparison of Example 2, Comparative Example 2, and Comparative Example 3 leads to the following observation. By forming an intermediate layer serving as a barrier between the functional pattern and the sticking layer, the material of the functional pattern and the material of the sticking layer can be prevented from affecting each other. Accordingly, the material of the sticking layer can be selected more freely. In addition, in out observation, a solubility-parameter difference of 7 made the materials less compatible with each other, but a solubility-parameter difference of 2.1 made the materials more compatible with each other. The observation leads to an assumption that a solubility-parameter difference approximately of 5 is the dividing line in the present invention to separate the cases of compatibility from the cases of incompatibility.

### (Example 3)

### (Fabrication of Transfer Film for Firing)

A transfer film for firing described in Embodiment 3 was fabricated by the following procedure.

As the first peelable film, a PET film including a weakly-sticking layer and known as "SRL-0754" (manufactured by LINTEC Corporation, film size: 20 cm × 30 cm, thickness: 75 µm) was prepared.

As the second peelable film, a PET film including a silicone-based mold-release layer and known as "A31" (manufactured by Teijin DuPont Films Japan Limited, film size: 20 cm × 30 cm, thickness: 38 µm) was prepared.

As the coating liquid for the functional pattern, a color paste similar to the one used in Example 1 was fabricated.

As the coating liquid for the intermediate layer, an intermediate-layer paste was prepared by diluting a polyvinyl-acetal-based adhesive agent known as "KW1" (manufactured by Sekisui Chemical Co., Ltd.) with a mixture solvent of 50-part water and 50-part isopropyl alcohol. This mixture solvent had a solubility parameter (SP) of 18.

As the coating liquid for the sticking layer, a sticking-layer paste was prepared by using an acryl-based sticking agent known as "SK1309" (manufactured by Soken Chemical & Engineering Co., Ltd.).

As the coating liquid for the protective layer, a protective-layer paste was prepared by diluting polyethylene-oxide-based resin known as "PEO-8Z" (manufactured by Sumitomo Seika Chemicals Co., Ltd.) with a solvent of water (solubility parameter (SPc) = 23.4).

On the mold-release layer of the second peelable film, the sticker-layer paste was printed using a Meyer bar coating machine so as to give a size of 5 cm × 10 cm and a film thickness of 5 µm. Thus, the sticking layer was formed.

The intermediate-layer paste was coated using an applicator so as to cover the sticking layer and to give a size of 6 cm × 12 cm and a film thickness of 2 µm on the sticking layer. Thus, the intermediate layer was formed.

The color paste was printed using a screen-printing machine at around the center of the intermediate layer so as to give a size of 2 cm × 5 cm and a film thickness of 15 µm. Thus the functional pattern was formed.

The protective layer paste was coated using an applicator so as to be laid over the intermediate layer and to cover the functional pattern and to give a size of 6 cm × 12 cm and a film thickness of 3 µm on the functional pattern. Thus the protective layer was formed.

The second peelable film was bonded from the sticking-layer side in such a way to cover the protective layer.

### (Fabrication of Substrate with Functional Pattern)

A substrate with a functional pattern was fabricated by the following procedure.

As the substrate, a glass plate (size: 30 cm × 30 cm) manufactured by the float process was prepared.

The second peelable film was peeled off from the transfer film for firing. The sticking layer of the transfer film for firing was faced to a surface of the glass plate. While bent at a curvature of Φ 5 mm, the transfer film for firing was pasted to the glass plate with a pressure of 0.5 kg/cm applied, using a rubber roller, onto the first peelable film. Then, the first peelable film was peeled off. Thus fabricated was a glass plate to which a laminate including a functional pattern had been transferred.

Then, the glass plate thus fabricated was fired in a firing furnace. The firing conditions were: the temperature was raised from room temperature up to 650 °C at a rate of temperature increase of 20°C/min; this temperature was kept for 30 minutes; then the glass plate was radiatively cooled in the furnace down to 100°C or even lower.

After that, the cooled glass plate with a functional pattern was taken out of the firing furnace.

### (Comparative Example 4)

As the coating liquid for the intermediate layer, an intermediate-layer paste was prepared by diluting an ethylcellulose-based resin known as "N4" (manufactured by Dow Corning Corporation) with a solvent of toluene (solubility parameter (SP) = 8.9). To coat the intermediate-layer paste, a Meyer bar coating machine was used. The size and the film thickness of the intermediate layer were the same as those in Example 3.

A transfer film for firing was fabricated by a similar method to the one employed in Example 3 except the above-described forming of the intermediate layer.

Then, a glass plate with a functional pattern was fabricated by a similar method to the one employed in Example 3.

### Example 4

### (Fabrication of Transfer Film for Firing)

A transfer film for firing described in Embodiment 3 was fabricated by the following procedure. The sequence of forming the layers of the laminate including the functional pattern of the transfer film for firing in Example 4 was opposite to the sequence of forming the layers of the corresponding laminate in Example 3.

As the first peelable film, a PET film including a silicone-based mold-release layer and known as "A54" (manufactured by Teijin DuPont Films Japan Limited, film size: 20 cm × 30 cm, thickness: 50 µm) was prepared.

As the second peelable film, a PET film including a silicone-based mold-release layer and known as "A31" (manufactured by Teijin DuPont Films Japan Limited, film size: 20 cm × 30 cm, thickness: 25 µm) was prepared.

As the coating liquid for the functional pattern, a color paste similar to the one employed in Example 1 was fabricated.

As the coating liquid for the intermediate layer, an intermediate-layer paste was prepared by diluting a polyvinyl-acetal-based resin known as "KW3" (manufactured by Sekisui Chemical Co., Ltd.) with a mixture solvent of 50-part water and 50-part isopropyl alcohol. This mixture solvent had a solubility parameter (SP) of 18.

As the coating liquid for the sticking layer, a sticking-layer paste was prepared by using an acryl-based sticking agent known as "SK1309" (manufactured by Soken Chemical & Engineering Co., Ltd.).

As the coating liquid for the protective layer, a protective-layer paste was prepared by diluting methylcellulose-based resin known as "60MP50" (manufactured by Matsumoto Yushi-Seiyaku Co., Ltd.) with a solvent of water (solubility parameter (SPc) = 23.4).

On the mold-release layer of the first peelable film, the protective layer paste was coated using an applicator so as to give a size of 6 cm × 12 cm and a film thickness of 2 µm. Thus the protective layer was formed.

The color paste was printed using a screen-printing machine at around the center of the protective layer so as to give a size of 2 cm × 5 cm and a film thickness of 15 µm. Thus, the functional pattern was formed.

The intermediate layer paste was coated using a Meyer bar coating machine so as to be laid over the protective layer and to cover the functional pattern and to give a size of 6 cm ×12 cm and a film thickness of 2 µm on the functional pattern. Thus, the intermediate layer was formed.

The sticking-layer paste was coated using a Meyer bar coating machine so as to be laid over the intermediate layer and to give a size of 6 cm × 12 cm and a film thickness of 3 µm. Thus the sticking layer was formed.

The second peelable film was bonded from the mold-release-layer side so as to cover the sticking layer.

### (Fabrication of Substrate with Functional Pattern)

A substrate with a functional pattern was fabricated by the following procedure.

As the substrate, a glass plate (size: 30 cm × 30 cm) manufactured by the float process was prepared.

The second peelable film was peeled off from the transfer film for firing. The sticking layer of the transfer film for firing was faced to a surface of the glass plate, and the transfer film for firing was pasted thereto with a pressure of 0.5 kg/cm applied, using a rubber roller, onto the first peelable film. Then, the first peelable film was peeled off. Thus fabricated was a glass plate to which a laminate including a functional pattern had been transferred.

Then, the glass plate thus fabricated was fired in a firing furnace. The firing conditions were: the temperature was raised from room temperature up to 650°C at a rate of temperature increase of 500°C/min; this temperature was kept for 10 minutes; then the glass plate was radiatively cooled in the furnace down to 100°C or even lower.

After that, the cooled glass plate with a functional pattern was taken out of the firing furnace.

### (Comparative Example 5)

As the coating liquid for the protective layer, an protective-layer paste was prepared by diluting an acryl-based resin known as "BR1122" (manufactured by Mitsubishi Rayon Co., Ltd.) with a solvent of toluene (solubility parameter (SPc) = 8.9). To coat the protective-layer paste, a Meyer bar coating machine was used. The protective layer thus formed had a film thickness of 3 µm, and a size that is the same as the corresponding size in Example 4.

A transfer film for firing was fabricated by a similar method to the one employed in Example 4 except the above-described forming of the protective layer. Then, a glass plate with a functional pattern was fabricated by a similar method to the one employed in Example 4.

### (Assessment)

Table 4 shows: the solubility parameter of the organic material contained in the functional pattern; the solubility parameter of the solvent contained in the intermediate layer; the solubility parameter of the solvent contained in the protective layer; the difference between each two of these solubility parameters; the assessment of the shape of the functional pattern; the assessment of the transferability; and the assessment of the firing ability. Table 4 shows these data for Examples 3 and 4, as well as for Comparative Examples 4 and 5. The assessment of the shape of the functional pattern is shown by the following symbols: "○" meaning that the pattern shape had no such defects as bleeding or cracking, and so was favorable; and "×" meaning that the pattern shape had some defects and so was unfavorable. The assessment of the transferability is shown by the following symbols: "○ meaning that the transfer was favorably done; and "△" meaning that the transfer was unstable. The assessment of the firing ability is shown by the following symbols: "○" meaning that the firing was favorably done with no such defects as distortion, cracks, and flaking observed in the fired body of the functional pattern; and "×" meaning that there was a defect.

**[Table 4]**

| | Solubility parameter | | | Solubility parameter difference | | Pattern shape | Transferability | Firing ability |
|---|---|---|---|---|---|---|---|---|
| | Intermediate layer SP | Functional pattern SPb | Protective layer SPc | \|SP - SPb\| | \|SPc - SPb\| | | | |
| Example 3 | 18 | 11 | 23.4 | 7 | 12.4 | ○ | ○ | ○ |
| Comparative Example 4 | 9 | 11 | 23.4 | 2 | 12.4 | × | △ | × |
| Example 4 | 18 | 11 | 23.4 | 7 | 12.4 | ○ | ○ | ○ |
| Comparative Example 5 | 18 | 11 | 8.9 | 7 | 1.9 | × | ○ | × |

Examples 3 and 4 had favorable assessment results of all of the pattern shape, the transferability, and the firing ability.

In the case of the laminate including a functional pattern in Comparative Example 4, bleeding occurred in the functional pattern. In addition, cracks occurred while the substrate with the functional pattern was being dried. Consequently, the assessment result of the pattern shape was unfavorable. Concerning the transferability of this laminate, the reproducibility of the transfer was unstable. The transferring of the functional pattern was tried using several samples. Successful transferring was accomplished in some of the samples, but the transferring failed in others. The firing ability was checked using the samples of successful transferring. The adhesiveness of the fired body of the functional pattern was weak, and deformation of the shape of the fired body was observed. Accordingly, the firing ability was unfavorable.

In the case of the laminate including a functional pattern in Comparative Example 5, bleeding occurred in the functional pattern. In addition, cracks occurred while the substrate with the functional pattern was being dried. Consequently, the assessment result of the pattern shape was unfavorable. The assessment result of the transferability was favorable, but the assessment result of the combustibility was unfavorable. This is because there occurred color fading and deformation of the pattern shape in the fired body of the functional pattern.

### (Comparison)

Firstly, Example 3 is compared with Comparative Example 4.

There were no signs of the occurrence of the mixing of the materials between the functional pattern and the intermediate layer in Example 3. A possible reason for this is that the solubility-parameter difference between the organic material contained in the functional pattern and the solvent contained in the intermediate layer was 7, meaning that the organic material and the solvent formed a combination that was unlikely to be compatible. Likewise, there were no signs of the occurrence of the mixing of the materials between the functional pattern and the protective layer, either. A possible reason for this is also that the solubility-parameter difference between the organic material contained in the functional pattern and the solvent contained in the protective layer was 12.4, meaning that the organic material and the solvent also formed a combination that was unlikely to be compatible.

In contrast, bleeding was observed between the functional pattern and the intermediate layer in Comparative Example 4. The breeding occurred probably because the materials of the functional pattern and the intermediate layer had been mixed together. A possible reason for this is that the solubility-parameter difference between the organic material contained in the functional pattern and the solvent contained in the intermediate layer was 1. 9, meaning that the organic material and the solvent formed a combination that was likely to be compatible. It seems that such dissolution affected even the sticking layer, so that the sticking performance of the sticking layer was weakened, resulting in unstable transferability. Note that there were no signs of the occurrence of the mixing of the materials between the functional pattern and the protective layer. As in the case of Example 3, a possible reason for this is that the solubility-parameter difference between the organic material contained in the functional pattern and the solvent contained in the protective layer was 12.4.

Subsequently, Example 3 is compared with Example 4.

As described above, in Example 3, the laminate including the functional pattern of the transfer film for firing was formed in a sequence, and in Example 4, the corresponding laminate was formed in the opposite sequence. Accordingly, the materials of the intermediate layer and the protective layer used in Example 3 differ from their corresponding materials in Example 4. However, the solvents for the layers did not differ from each other between Examples 3 and 4. Accordingly, the same solubility-parameter difference was obtained in both of Examples 3 and 4. Consequently, as Table 4 shows, the assessment results for Example 4 were as favorable as the corresponding assessment results for Example 3.

The comparison of Examples 3 and 4 reveals what is important for the purpose of forming a substrate to which the transfer film for firing and the functional pattern have been transferred favorably. It is a large solubility-parameter difference between the organic material contained in the functional pattern and the solvent contained in the contact layer. The solubility-parameter difference must be large enough to make the organic material and the solvent less likely to be compatible with each other. Note that such a large solubility-parameter difference must be secured irrespective of the sequence in which the layers included in the transfer film for firing are formed.

Subsequently, Example 4 is compared with Comparative Example 5.

As described above, the assessment results for Example 4 were favorable.

In contrast, bleeding was observed between the functional pattern and the protective layer in Comparative Example 5. The breeding occurred probably because the materials of the functional pattern and the protective layer had been mixed together. A possible reason for this is that the solubility-parameter difference between the organic material contained in the functional pattern and the solvent contained in the protective layer was 1.9, meaning that the organic material and the solvent formed a combination that was likely to be compatible. Note that there were no signs of the occurrence of the mixing of the materials between the functional pattern and the intermediate layer. As in the case of Example 4, a possible reason for this is that the solubility-parameter difference between the organic material contained in the functional pattern and the solvent contained in the intermediate layer was 7. The transferability of the laminate was favorable probably because the intermediate layer served as a barrier.

Deformation of the pattern shape and color fading were observed in the fired body of the functional pattern. A possible reason for this is that the organic material contained in the functional pattern was dissolved by the solvent contained in the protective layer. Such dissolution made the composition of the functional pattern ununiform, so that the mixing state of the pigment, which was the inorganic component contained in the functional pattern, and the glass frit was changed.

The comparisons among Example 3, Example 4, Comparative Example 4, and Comparative Example 5 reveal what is important for the purpose of obtaining a favorable fired body of the functional pattern. It is a larger solubility-parameter difference between the organic material contained in the functional pattern and the solvent contained in the contact layer. To put it differently, the organic material and the solvent must be less likely to be compatible. In addition, such a condition must be satisfied between the functional pattern contained in the laminate and all the contact layers contained in the laminate.

### BRIEF DESCRIPTION OF THE DRAWINGS

[Fig. 1] Fig. 1 is an enlarged schematic sectional diagram illustrating a transfer film for firing according to one embodiment of the present invention.
[Fig. 2] Fig. 2 is an enlarged schematic sectional diagram illustrating a transfer film for firing according to another embodiment of the present invention.
[Fig. 3] Fig. 3 is an enlarged schematic sectional diagram illustrating a transfer film for firing according to still another embodiment of the present invention.
[Fig. 4] Fig. 4 is an enlarged schematic sectional diagram illustrating a transfer film for firing according to a different embodiment of the present invention.
[Fig. 5] Fig. 5 is an enlarged schematic sectional diagram illustrating a transfer film for firing of another different embodiment of the present invention.
[Fig. 6] Fig. 6 is an enlarged schematic sectional diagram illustrating a transfer film for firing of still another different embodiment of the present invention.
   - 1: Peelable film (first peelable film)
   - 2: Functional pattern
   - 3: Sticking layer
   - 4: Intermediate layer
   - 5: Protective layer
   - 6: Second peelable film

## Claims

1. A transfer film for firing used for forming a fired body of a functional pattern by transferring a laminate having the functional pattern to a surface of a substrate, followed by firing, the transfer film for firing **characterized in that**
the transfer film for firing comprises:
a peelable film; and
the laminate that is formed so as to be in contact with one of surfaces of the peelable film,
the laminate further comprises:
a functional pattern; and
a contact layer which is formed of a single or more layers, and which is formed so as to be in direct contact with one of surfaces of the functional pattern,
the functional pattern contains:
an inorganic powder; and
an organic material that is removable by firing, the contact layer contains:
an organic material that is removable by firing; and
a solvent, and
the organic material contained in the functional pattern is not compatible with the solvent contained in the contact layer.

2. The transfer film for firing according to claim 1 **characterized in that** a solubility parameter (SPb) of the organic material contained in the functional pattern and a solubility parameter (SP) of the solvent contained in the contact layer satisfy a relation of 5 < |SP - SPb.

3. The transfer film for firing according to claim 1 or 2 **characterized in that** the contact layer is a sticking layer that is bonded to the surface of the substrate before the laminate is transferred to the substrate.

4. The transfer film for firing according to claim 1 or 2 **characterized in that**
the laminate further comprises a sticking layer that is bonded to the surface of the substrate when the laminate is transferred to the substrate, and
the contact layer is an intermediate layer that is sandwiched between the functional pattern and the sticking layer.

5. The transfer film for firing according to any of claims 1 to 4 **characterized in that** one layer in the contact layer is a protective layer provided to protect one of the surfaces of the functional pattern that is indirectly in contact with that the one surface of the peelable film.
